# EUROPÄISCHE PATENTANMELDUNG

(11) **EP 0 679 051 A2**
(43) Veröffentlichungstag der Anmeldung: **25.10.1995**
(21) Anmeldenummer: 95102815.8
(22) Anmeldetag: 28.02.1995
(51) Int. Cl.: H05K 1/14, H01H 13/70, H04M 1/23

(54) **Kontaktierung von Betätigungs- und Anzeigemitteln**

(30) Priorität: 19.04.1994 DE 4416096
(71) Anmelder: DETEWE - DEUTSCHE TELEPHONWERKE Aktiengesellschaft & Co., D-10997 Berlin (DE)
(72) Erfinder: Brettschneider, Dieter, D-12357 Berlin (DE); Klein, Wolfgang, D-12349 Berlin (DE)

(57) **Zusammenfassung**

Zum Kontaktieren von Betätigungs- und Anzeigemitteln mit auf Leiterplatten angeordneten Baugruppen in Gehäusen von Endgeräten der elektrischen Nachrichtentechnik wird vorgeschlagen, die Leiterzüge (11) und Anschlußkontakte (12) der Betätigungs- und Anzeigemittel auf einer Distanzplatte (10) oder direkt auf Gehäuseteilen anzuordnen . Über Leitfolien (15) oder Leitgummis werden die Leiterzüge (11) und Anschlußkontakte (12) mit der Leiterplatte (20) verbunden.

## Beschreibung

Die Erfindung betrifft die Kontaktierung zwischen Betätigungs- und Anzeigemitteln und auf Leiterplatten angeordnete Baugruppen in Gehäusen von Endgeräten der elektrischen Nachrichtentechnik, insbesondere in Kommunikations-Endgeräten.

In Gehäusen von Kommunikations-Endgeräten werden die mäanderförmigen Leiterzüge der Tastatur und die Anschlußkontakte von Flüssigkristall-Anzeigen auf einer unterhalb dieser Bauelemente liegenden Leiterplatte angeordnet. Um eine beidseitige Bestückung der Leiterplatte zu ermöglichen, wurde eine Distanzplatte als Abstandshalter zwischen Schaltmatte der Tastatur und der Leiterplatte vorgeschlagen. Dadurch können im Bereich der Distanzplatte zusätzliche Bauelemente, vorzugsweise SMD-Bauelemente, auf der Leiterplatte untergebracht werden ( DE 43 07 613 ).

Durch die Anordnung der Kontaktierungen auf der Leiterplatte ist die Lage der Leiterplatte im Gerät vorbestimmt und außerdem erfordern die Kontaktierungen größere Abmaße der Leiterplatte.

Der Erfindung lag die Aufgabe zugrunde, die Leiterplattengröße zu optimieren, so daß bei der Herstellung ein Leiterplattennutzen entweder mehr Leiterplatten aufweist oder der Nutzen selbst kleinere Abmaße erhält.

Diese Aufgabe ist durch die Erfindung gelöst, wie sie im Kennzeichnungsteil des ersten Patentanspruches dargelegt ist. Weitere vorteilhafte Maßnahmen beschreiben die Unteransprüche.

Anhand einer aus zwei Figuren bestehenden Zeichnung wird die Erfindung nachfolgend näher beschrieben. In der Zeichnung zeigen die
- Fig. 1: eine Ausführung, bei der die Kontaktierungen einer Distanzplatte und die
- Fig. 2: eine Ausführung, bei der die Kontaktierungen Gehäuseteilen zugeordnet sind.

In beiden Figuren tragen gleiche Bauteile und Bauelemente dieselben Bezugszeichen.

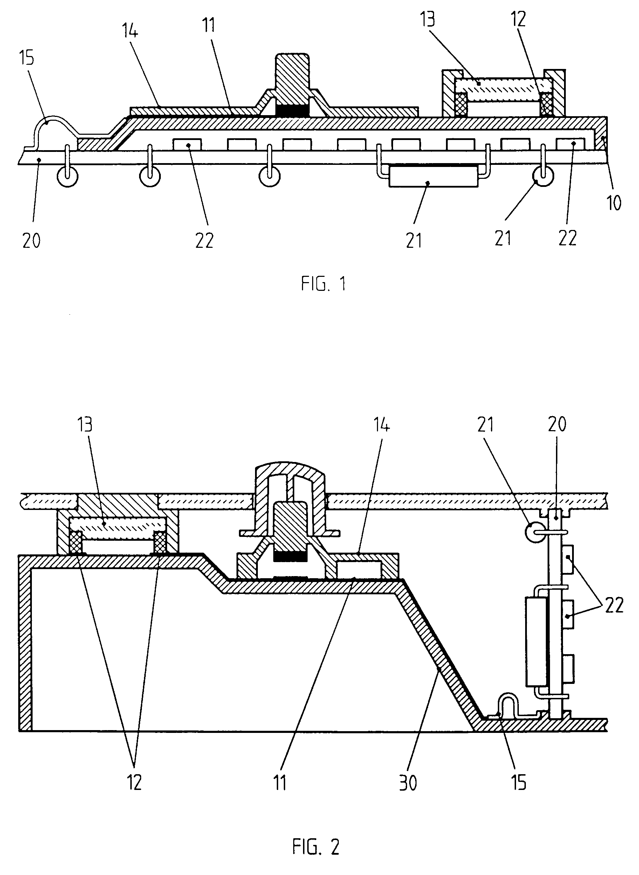

In der Fig. 1 ist als Betätigungsmittel eine Tastatur mit mäanderförmigen Leiterzügen 11 und mit einer Schaltmatte 14 vorgesehen. Die Schaltmatte 14 ist direkt auf die mäanderförmigen Leiterzüge 11 gesetzt. Als Anzeigemittel ist eine Flüssigkristallanzeige 13 dargestellt. Die mäanderförmigen Leiterzüge 11 der Tastatur und die Anschlußkontakte 12 der Flüssigkristallanzeige 13 sind auf einer Distanzplatte 10 angeordnet, die sich beispielsweise auf der Leiterplatte 20 abstützt. Die Leiterzüge 11 und die Anschlußkontakte 12 sind vorzugsweise durch Bedrucken aufgebracht.

Die Verbindung zwischen Leiterzügen 11 und den Anschlußkontakten 12 mit der Leiterplatte 20 wird durch Leitfolien 15 oder Leitgummis hergestellt.

Durch das Aufbringen der Leiterzüge 11 und der Anschlußkontakte 12 auf die Distanzplatte 10 anstelle in bekannter Weise auf die Leiterplatte selbst, entsteht ein großflächiger Freiraum auf der Leiterplatte 14. Diese ist damit beidseitig voll bestückbar, z. B. mit verdrahteten Bauelementen 21 auf der einen und mit geklebten Bauelementen 22 auf der anderen Seite.

In der Fig. 2 werden die Leiterzüge 11 und die Anschlußkontakte 12 direkt Gehäuseteilen 30 zugeordnet. Hierdurch kann die Leiterplatte 20 in einem beliebigen freien Raum im Gehäuse des Endgerätes untergebracht werden.

## Patentansprüche

1. Kontaktierung zwischen Betätigungs- und Anzeigemitteln und auf Leiterplatten angeordnete Baugruppen in Gehäusen von Endgeräten der elektrischen Nachrichtentechnik, insbesondere in Kommunikations-Endgeräten, gekennzeichnet durch Anordnung der Leiterzüge (11) und Anschlußkontakte (12) der Betätigungs- und Anzeigemittel auf einer Distanzplatte (10) zur Leiterplatte (20) und Verbindung der Leiterzüge (11) und der Anschlußkontakte (12) über Leitfolien (15) mit der Leiterplatte (20).

2. Kontaktierung nach Anspruch 1, gekennzeichnet durch Anordnung der Leiterzüge (11) und Anschlußkontakte (12) der Betätigungs- und Anzeigemittel auf Gehäuseteilen (30) der Endgeräte.

3. Kontaktierung nach Anspruch 1 und 2, gekennzeichnet durch Aufbringen der Leiterzüge (11) und der Anschlußkontakte (12) der Betätigungs- und Anzeigemittel durch Bedrucken auf die Distanzplatte (10) bzw. die Gehäuseteile (30).

4. Verfahren nach Anspruch 1, gekennzeichnet durch Verwenden von Leitgummis anstelle von Leitfolien (15) .
